# FASCICULE DE BREVET EUROPEEN

(11) **EP 2 577 708 B1**
(45) Date de publication et mention de la délivrance du brevet: **10.12.2014**
(21) Numéro de dépôt: 11730719.9
(22) Date de dépôt: 01.06.2011
(51) Int. Cl.: H01J 37/244, H01J 37/32

(54) **DISPOSITIF DE MESURE DE DOSE POUR L'IMPLANTATION IONIQUE EN MODE IMMERSION PLASMA**
GERÄT ZUM MESSEN DER IONENDOSIS BEI DER PLASMAIMMERSIONSIONENIMPLANTATION
ION DOSE MEASURING DEVICE FOR PLASMA IMMERSION ION IMPLANTATION

(30) Priorité: 03.06.2010 FR 1002353
(43) Date de publication de la demande: 10.04.2013
(73) Titulaire: Ion Beam Services, 13790 Peynier (FR)
(72) Inventeur: TORREGROSA, Frank, F-13109 Simiane (FR); ROUX, Laurent, F-13013 Marseille (FR)
(74) Mandataire: Renaud-Goud, Thierry
(86) Numéro de dépôt international: PCT/FR2011/000323
(87) Numéro de publication internationale: WO 2011/151540

(56) Documents cités:
- WO-A2-2010/075283
- US-A- 5 319 212
- KEIJI NAKAMURA ET AL: "Direct measurements of sheath-accelerated secondary electrons for monitoring the incident ion flux in plasma immersion ion implantation; Sheath-accelerated secondary electrons", PLASMA SOURCES SCIENCE AND TECHNOLOGY, INSTITUTE OF PHYSICS PUBLISHING, BRISTOL, GB, vol. 11, no. 2, 1 mai 2002 (2002-05-01), pages 161-164, XP020069938, ISSN: 0963-0252, DOI: DOI:10.1088/0963-0252/11/2/306
- NAKAMURA K ET AL: "Development of a new technique for high-energy secondary-electron measurements in plasma immersion ion implantation", PLASMA SOURCES SCIENCE AND TECHNOLOGY, INSTITUTE OF PHYSICS PUBLISHING, BRISTOL, GB, vol. 6, no. 1, 1 février 1997 (1997-02-01) , pages 86-90, XP020070209, ISSN: 0963-0252, DOI: DOI:10.1088/0963-0252/6/1/012
- GAHAN D ET AL: "Comparison of plasma parameters determined with a Langmuir probe and with a retarding field energy analyzer; RFEA and Langmuir probe comparison", PLASMA SOURCES SCIENCE AND TECHNOLOGY, INSTITUTE OF PHYSICS PUBLISHING, BRISTOL, GB, vol. 17, no. 3, 1 août 2008 (2008-08-01), page 35026, XP020145160, ISSN: 0963-0252, DOI: DOI:10.1088/0963-0252/17/3/035026
- DREVAL M ET AL: "Retarding field energy analyzer for the Saskatchewan Torus-Modified plasma boundary", REVIEW OF SCIENTIFIC INSTRUMENTS, AIP, MELVILLE, NY, US, vol. 80, no. 10, 22 octobre 2009 (2009-10-22), pages 103505-103505, XP012127922, ISSN: 0034-6748, DOI: DOI:10.1063/1.3247902

## Description

La présente invention concerne un dispositif de mesure de dose pour l'implantation ionique en mode immersion plasma.

Le domaine de l'invention est celui des implanteurs ioniques opérant mode immersion plasma. Ainsi, l'implantation ionique d'un substrat consiste à l'immerger dans un plasma et à le polariser en tension négative, de quelques dizaines de Volts à quelques dizaines de kilovolts (généralement moins de 100 kV), ceci de façon à créer un champ électrique capable d'accélérer les ions du plasma vers le substrat de sorte qu'ils s'y implantent. Les atomes ainsi implantés sont dénommés dopants.

La profondeur de pénétration des ions est déterminée par leur énergie d'accélération. Elle dépend d'une part de la tension appliquée au substrat et d'autre part de la nature respective des ions et du substrat. La concentration d'atomes implantés dépend de la dose qui s'exprime en nombre d'ions par cm² et de la profondeur d'implantation.

Un des paramètres essentiels lors de l'implantation est la dose des dopants implantés. Cette dose doit être connue avec précision. Elle est obtenue par intégration des charges positives atteignant le substrat.

Ainsi, le document US 6,050,218 décrit un collecteur de charges pour estimer la dose d'implantation en immersion plasma. Le collecteur placé sous le substrat est une cage de Faraday qui collecte une partie des ions du plasma. On en déduit le courant d'implantation. Seules les ions positifs sont pris en compte.

Les documents WO 01 41183 et WO 00 08670 traitent également de la dosimétrie en implantation ionique. C'est encore un collecteur du type cage de Faraday qui est utilisé pour récupérer une partie des ions positifs. Ce collecteur jouxte le substrat.

Le document WO 2005 / 104175 propose de limiter le biais de cette estimation en disposant une pluralité de collecteurs sur des rayons différents par rapport au centre du substrat. L'estimation est améliorée car la mesure se fait tout autour du substrat. Cependant, elle ne prend pas en compte les inhomogénéités radiales du plasma qui sont conséquentes.

Il convient toutefois de remarquer que les charges positives ne sont pas dues seulement aux ions positifs atteignant le substrat, mais qu'elles proviennent aussi de la génération d'électrons secondaires libérés à la surface du substrat.

Sur les implanteurs par faisceau d'ions, les électrons secondaires sont peu énergétiques, si bien qu'on peut les ramener vers le substrat au moyen d'une cage de Faraday qui entoure ce dernier, cette cage est fermée optiquement par une barrière de potentiel négatif.

Sur un implanteur fonctionnant en mode immersion plasma, les électrons secondaires sont accélérés avec une énergie sensiblement identique à celle des ions positifs du plasma, si bien qu'il est beaucoup plus difficile de les ramener vers le substrat.

**Il convient donc de détecter les électrons secondaires.**

**L'article de** KEIJI NAKAMURA ET AL : « Direct measurements of sheath-accelerated secondary électrons for monitoring the incident ion flux plasma immersion ion implantation ; Sheath-accelerated secondary electrons », PLASMA SOURCES SCIENCE AND TECHNOLOGY, INSTITUTE OF PHYSICS PUBLISHING, BRISTOL, GB, vol. 11, no. 2, 1 mai 2002 (2002-05-01), pages 161-164, XP020069938, ISSN: 0963-0252**, DOI: DOI: 10. 1088/0963-0252/11/2/306 propose un dispositif de mesure des électrons secondaires qui comporte uniquement une fenêtre en Béryllium. Cette fenêtre supprime les électrons peu énergétiques même si ceux-ci résultent de l'impact d'électrons énergétiques.**

**L'article de** NAKAMURA K ET AL : « Development of a new technique for high-energy secondary-electron measurements in plasma immersion ion implantation », PLASMA SOURCES SCIENCE AND TECHNOLOGY, INSTITUTE OF PHYSICS PUBLISHING, BRISTOL, GB, vol. 6, no. 1, 1 février 1997 (1997-02-01), pages 86-90**, XP020070209, ISSN: 0963-0252, DOI: DOI: 10. 1088/0963-0252/6/1/012 enseigne un détecteur d'électrons secondaires qui est un scintillateur. Il s'ensuit que seuls les électrons très énergétiques sont pris en compte.**

**L'article de** GAHAN D ET AL : « Comparison of plasma parameters determined with a Langmuir probe and with a retarding field energy analyser ; RFEA and Langmuir probe comparison », PLASMA SOURCES SCIENCE AND TECHNOLOGY, INSTITUTE OF PHYSICS PUBLISHING, BRISTOL, GB, vol. 17, no. 3, 1 août 2008 (2008-08-01), page 35026, XP020145160, ISSN: 0963-0252**, DOI: DOI: 10. 1088/0963-0252/17/3/035026 décrit un détecteur RFEA (pour Retarding Field Energy Analyser en anglais). Ce détecteur comporte seulement deux électrodes si bien que les électrons peu énergétiques issus du plasma sont pris en compte.**

**On connaît par ailleurs l'article de** DREVAL M ET AL : « Retarding field energy analyser for the Saskatchewan Torus-Modified plasma boundary », REVIEW OF SCIENTIFIC INSTRUMENTS, AIP, MELVILLE, NY, US, vol. 80, no. 10, 22 octobre 2009 (2009-10-22), pages 103505-103505, XPO12127922, ISSN: 0034-6748**, DOI: DOI: 10. 1063/1.3247902 qui mentionne aussi un détecteur RFEA pour collecter les ions du plasma. Le problème traité par ce document ne se pose pas dans le cadre de la présente invention.**

Ainsi, le document US 5 319 212 enseigne un dispositif de mesure de dose comportant un module d'estimation du courant d'implantation, comportant aussi un détecteur d'électrons secondaires et comportant encore un circuit de contrôle pour estimer le courant ionique par différentiation du courant d'implantation et du courant issu du détecteur d'électrons secondaires.

Le détecteur d'électrons secondaires est apte à mesurer uniquement les électrons lents dont l'énergie maximale est imposée par une tension d'alimentation nécessairement faible. S'il en était autrement, le plasma serait perturbé.

Le document WO 2010/075283 divulgue lui aussi un dispositif de mesure de dose comportant un module d'estimation du courant d'implantation, comportant aussi un détecteur d'électrons secondaires et comportant encore un circuit de contrôle pour estimer le courant ionique par différentiation du courant d'implantation et du courant issu du détecteur d'électrons secondaires.

La remarque précédente relative au détecteur d'électrons secondaires s'applique ici également.

Dans les deux documents précédents, le détecteur est peu efficace pour éliminer les électrons lents ou les ions provenant du plasma. Si la tension d'alimentation du détecteur est ajustée pour bloquer les électrons du plasma, certains ions sont susceptibles d'être pris en compte et inversement. Il conviendrait que le détecteur d'électrons secondaires comptabilise uniquement les électrons rapides.

L'invention se propose d'apporter une amélioration à cette situation.

Selon l'invention, un dispositif de mesure de dose pour l'implantation ionique comporte un module d'estimation du courant d'implantation, un détecteur d'électrons secondaires et un circuit de contrôle pour estimer le courant ionique par différentiation du courant d'implantation et du courant issu du détecteur d'électrons secondaires ; de plus, ce détecteur d'électrons secondaires énergétiques comporte un collecteur supportant exclusivement trois électrodes isolées les unes des autres :
- une première électrode de répulsion pour repousser les charges à écarter d'un signe prédéterminé, cette électrode étant munie d'au moins un orifice pour permettre le passage des électrons,
- une deuxième électrode de répulsion pour repousser les charges à écarter du signe opposé, cette électrode étant aussi munie d'au moins un orifice pour permettre le passage des électrons, et
- une électrode de sélection, cette électrode étant également munie d'au moins un orifice pour permettre le passage des électrons.

Suivant un mode de mise en oeuvre privilégié de l'invention, les orifices de ces électrodes sont alignés sur un cylindre de conduction qui est formé par une ouverture du détecteur d'électrons secondaires.

D'autre part, le collecteur se présente comme une coupelle.

Suivant une caractéristique additionnelle de l'invention, les électrodes sont en aluminium.

De préférence, l'espacement entre deux électrodes consécutives est compris entre 6 et 10 mm.

Idéalement, les ouvertures desdites électrodes ont une surface comprise entre 15 et 30 mm².

Suivant un premier mode de réalisation du détecteur d'électrons secondaires, les électrodes sont constituées par des grilles.

Avantageusement, la transparence de ces grilles est supérieure à 50%.

Il est de plus souhaitable que, la distance entre deux grilles consécutives étant notée h, le diamètre des orifices de ces grilles étant noté D, le rapport h/D soit supérieur à 1.

Suivant un second mode de réalisation du détecteur d'électrons secondaires, les électrodes sont constituées par des par des anneaux.

De même, la distance entre deux anneaux consécutifs étant notée h, le diamètre du cylindre de conduction étant noté D, le rapport h/D est supérieur à 1.

On améliore encore la mesure si le dispositif comporte de plus un spectromètre pour estimer la proportion d'une espèce ionique prédéterminée, le circuit de contrôle comprenant des moyens pour affecter cette proportion au courant ionique.

Il peut être par ailleurs souhaitable de prévoir au moins un détecteur d'électrons secondaires additionnel.

La présente invention apparaîtra maintenant avec plus de détails dans le cadre de la description qui suit d'exemples de réalisation donnés à titre illustratif en se référant aux figures jointes parmi lesquelles :
- la figure 1 représente un implanteur en coupe schématique verticale,
- la figure 2 représente une vue en coupe schématique d'un premier mode de réalisation d'un détecteur selon l'invention,
- la figure 3 représente une vue en coupe schématique d'un second mode de réalisation d'un détecteur, plus particulièrement :
- la figure 3a, une première variante de ce second mode de réalisation, et
- la figure 3b, une seconde variante de ce second mode de réalisation.

Les éléments présents sur plusieurs figures sont affectés d'une seule et même référence.

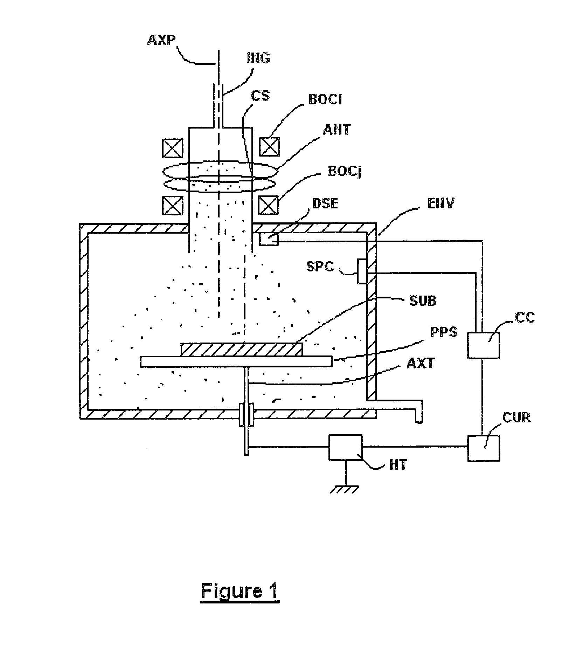

Tel que représenté sur la figure 1, un implanteur ionique comporte plusieurs éléments agencés à l'intérieur et à l'extérieur d'une enceinte à vide ENV. Pour les applications microélectroniques, il est préconisé d'utiliser une enceinte en alliage d'aluminium si l'on souhaite limiter la contamination en éléments métalliques tels que Fer, Chrome, Nickel ou Cobalt. Un revêtement en silicium ou en carbure de Silicium peut aussi être utilisé.

Un plateau porte substrat PPS, se présentant sous la forme d'un disque à plan horizontal, mobile autour de son axe vertical AXT, reçoit le substrat SUB devant subir l'implantation ionique. Il est relié à une alimentation électrique haute tension HT raccordée d'autre part à la masse.

La partie supérieure de l'enceinte ENV reçoit le corps de source CS, cylindrique, d'axe vertical AXP. Ce corps est en quartz. Il est extérieurement entouré, d'une part par des bobines de confinement BOCi, BOCj, et d'autre part par une antenne radiofréquence ANT extérieure. L'entrée de gaz plasmagène ING est coaxiale à l'axe vertical AXP du corps de source CS. Cet axe vertical AXP rencontre la surface du plateau porte substrat PPS sur lequel est disposé le substrat à implanter SUB.

Il est possible d'utiliser tout type de source plasma pulsée : décharge, ICP (pour « Inductively Coupled Plasma » en anglais), Helicon, micro-ondes, arc. Ces sources doivent travailler à des niveaux de pression suffisamment faibles pour que le champ électrique créé entre le plateau PPS à haute tension et l'enceinte ENV à la masse n'allume pas un plasma de décharge qui vienne perturber le fonctionnement pulsé de la source.

Plus précisément, le dispositif de mesure de dose comporte un module d'estimation du courant d'implantation CUR qui joue le rôle d'un ampèremètre connecté entre le porte-substrat PPS et la masse. Le courant d'implantation peut d'ailleurs être délivré directement par l'alimentation haute tension HT qui polarise le substrat SUB.

Il comporte également un détecteur d'électrons secondaires DSE et il comporte encore un circuit de contrôle CC pour estimer la densité surfacique du courant ionique par différentiation de la densité surfacique du courant d'implantation et de celle du courant issu du détecteur d'électrons secondaires.

Le détecteur d'électrons secondaires DSE est disposé face au substrat SUB.

On peut améliorer sensiblement la mesure de dose d'une espèce ionique donnée en disposant un spectromètre SPC, par exemple un spectromètre de masse ou un spectromètre optique, dans l'enceinte ENV. Ce spectromètre identifie la proportion de cette espèce dans le plasma et la fournit au circuit de contrôle CC qui la prend en compte. A titre d'exemple, la dose est estimée en multipliant le courant ionique par cette proportion.

On améliore encore le dispositif si l'on prévoit plusieurs détecteurs d'électrons secondaires répartis au-dessus du substrat. Il est ainsi possible de contrôler l'homogénéité d'implantation.

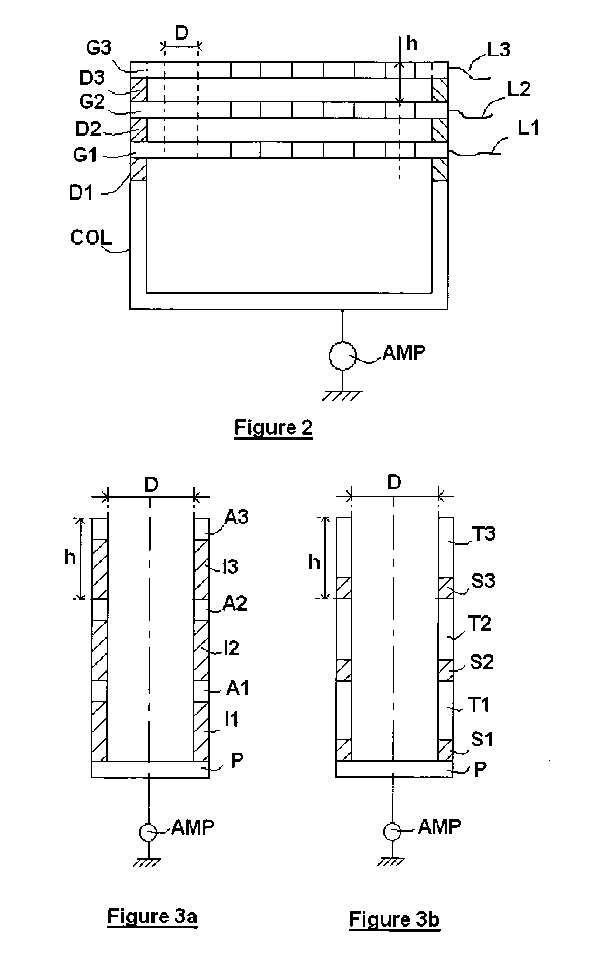

En référence à la figure 2, selon un premier mode de réalisation, ce détecteur DSE comprend un collecteur COL en forme de coupelle ou de cloche. Ce collecteur COL est relié à la masse par l'intermédiaire d'un ampèremètre AMP qui mesure le courant d'électrons secondaires.

Le collecteur COL est surmonté d'un premier isolateur D1 lui-même surmonté d'une première grille G1 électriquement conductrice.

La première grille G1 est surmontée d'un deuxième isolateur D2 lui-même surmonté d'une deuxième grille G2 électriquement conductrice.

La deuxième grille G2 est surmontée d'un troisième isolateur D3 lui-même surmonté d'une troisième grille G3 électriquement conductrice.

L'espacement entre les grilles G1-G2, G2-G3 est de préférence compris entre 6 et 10 mm. Il vaut typiquement 8 mm.

La transparence, pour mémoire, se définit comme le rapport de la surface des ouvertures d'une grille à la surface totale de cette grille. Dans le cas présent, la transparence doit être très élevée, de préférence supérieure à 50%.

Ces ouvertures doivent par ailleurs présenter une surface relativement importante de sorte qu'elles ne captent pas les espèces chargées qui doivent atteindre le collecteur. Avantageusement, cette surface est comprise entre 15 et 30 mm². A titre d'exemple, une ouverture circulaire présente un diamètre de l'ordre de 5 mm.

Le détecteur doit remplir les fonctions suivantes :
- récupérer les électrons secondaires énergétiques sur le collecteur COL,
- récupérer les électrons secondaires faiblement énergétiques sur le collecteur lorsqu'ils résultent de l'impact des électrons énergétiques,
- repousser les ions et les électrons faiblement énergétiques du plasma.

Il convient également d'éviter la création d'un plasma ou d'un arc au sein du détecteur du fait des tensions de polarisation appliquées sur les grilles G1, G2, G3. Pour ce faire, on pourra se référer à la loi de Paschen. Le détecteur ne doit pas apporter des espèces contaminantes pour le plasma. Pour les applications du domaine de la microélectronique, le choix de l'aluminium pour les conducteurs et de l'alumine pour les isolants est avantageux.

Il faut également éviter de perturber le plasma engendré au sein de l'implanteur ionique.

La première grille G1 est polarisée au moyen d'un premier câble L1 à une tension négative inférieure à 120 volts, typiquement 100 volts, par référence au collecteur COL.

La deuxième grille G2 est polarisée au moyen d'un deuxième câble L2 à une tension positive inférieure à 120 volts, typiquement 100 volts, par référence au collecteur COL.

La troisième grille G3 est polarisée au moyen d'un troisième câble L3 à une tension négative inférieure à 60 volts, typiquement 50 volts, par référence au collecteur COL.

En fait, selon ce premier mode de réalisation, le détecteur comporte une pluralité d'ouvertures, les ouvertures correspondant chacune aux trois orifices alignés des trois grilles.

Ainsi, ces ouvertures sont alignées chacune sur un cylindre de conduction de diamètre D.

En notant donc D le diamètre de ces ouvertures et h la distance qui sépare deux grilles, le rapport h/D a un ordre de grandeur de l'ordre de 1,5 et est en tout cas de préférence supérieur à 1.

Selon un second mode de réalisation, le détecteur ne présente plus une pluralité d'ouvertures mais il présente une structure tubulaire présentant une seule ouverture.

En référence à la figure 3a, selon une première variante, le collecteur P se présente maintenant comme un plateau. Ce collecteur est surmonté d'un premier anneau isolant I1, lui-même surmonté d'un premier anneau conducteur A1. Le diamètre interne de ces deux premiers anneaux vaut D. L'épaisseur du premier anneau isolant I1 est sensiblement plus importante que celle du premier anneau conducteur A1 et la somme de ces deux épaisseurs vaut h.

Le premier anneau conducteur A1 est surmonté d'un deuxième anneau isolant 12, lui-même surmonté d'un deuxième anneau conducteur A2.

Ces deuxièmes anneaux I2, A2 ont la même géométrie que les premiers anneaux I1, A1.

Le deuxième anneau conducteur A2 est surmonté d'un troisième anneau isolant I3, lui-même surmonté d'un troisième anneau conducteur A3. Ces troisièmes anneaux 13, A3 ont eux aussi la même géométrie que les premiers anneaux I1, A1.

Le collecteur P est ici encore raccordé à la masse par un ampèremètre AMP.

La géométrie reproduit celle des ouvertures du premier mode de réalisation. Ainsi, le rapport h/D est de préférence supérieur à 1.

Le premier A1, le second A2, respectivement le troisième anneau conducteur A3 sont polarisés comme la première G1, la deuxième G2, respectivement la troisième grille G3 du premier mode de réalisation.

En référence à la figure 3b, selon une deuxième variante, le collecteur P se présente toujours comme un plateau. Ce collecteur est surmonté d'une première bague isolante S1, elle-même surmontée d'une première bague conductrice T1. Le diamètre interne de ces deux premières bagues vaut encore D. L'épaisseur de la première bague isolante S1 est par contre sensiblement plus faible que celle de la première bague conductrice T1 et la somme de ces deux épaisseurs vaut toujours h.

La première bague conductrice T1 est surmontée d'une deuxième bague isolante S2, elle-même surmontée d'une deuxième bague conductrice T2.

Ces deuxièmes bagues S2, T2 ont la même géométrie que les premières bagues S1, T1.

De même, la deuxième bague conductrice T2 est surmontée d'une troisième bague isolante S3, elle-même surmontée d'une troisième bague conductrice T3. Ces troisièmes bagues S3, T3 ont elles aussi la même géométrie que les premières bagues S1, T1.

Ici encore, la géométrie reproduit celle des ouvertures du premier mode de réalisation. Ainsi, le rapport h/D est de préférence supérieur à 1.

En fait, selon cette seconde variante, les bagues sont analogues aux anneaux de la première variante, mais les épaisseurs des éléments isolants et conducteurs sont inversées.

Les exemples de réalisation de l'invention présentés ci-dessus ont été choisis eu égard à leurs caractères concrets. Il ne serait cependant pas possible de répertorier de manière exhaustive tous les modes de réalisation que recouvre cette invention.

## Revendications

1. Dispositif de mesure de dose pour l'implantation ionique, dispositif comportant un module d'estimation du courant d'implantation (CUR), un détecteur d'électrons secondaires (DSE), un circuit de contrôle (CC) pour estimer le courant ionique par différentiation dudit courant d'implantation et du courant issu dudit détecteur d'électrons secondaires,
**caractérisé en ce que**, ledit détecteur d'électrons secondaires énergétiques comporte un collecteur (COL, P) supportant exclusivement trois électrodes isolées les unes des autres :
- une première électrode de répulsion (G1, A1, T1) pour repousser les charges à écarter d'un signe prédéterminé, cette électrode étant munie d'au moins un orifice pour permettre le passage des électrons,
- une deuxième électrode de répulsion (G2, A2, T2) pour repousser les charges à écarter du signe opposé, cette électrode étant aussi munie d'au moins un orifice pour permettre le passage des électrons,
- une électrode de sélection (G3, A3, T3), cette électrode étant également munie d'au moins un orifice pour permettre le passage des électrons.

2. Dispositif selon la revendication 1, **caractérisé en ce que** les orifices desdites électrodes sont alignés sur un cylindre de conduction (D) qui est une ouverture dudit détecteur d'électrons secondaires (DSE)

3. Dispositif selon l'une quelconque des revendications 1 ou 2, **caractérisé en ce que** ledit collecteur (COL) se présente comme une coupelle.

4. Dispositif selon l'une quelconque des revendications 1 à 3, **caractérisé en ce que** lesdites électrodes (G1-A1-T1, G2-A2-T2, G3-A3-T3) sont en aluminium.

5. Dispositif selon l'une quelconque des revendications 1 à 4, **caractérisé en ce que** l'espacement entre deux électrodes (G1-G2, G2-G3) consécutives est compris entre 6 et 10 mm.

6. Dispositif selon l'une quelconque des revendications 1 à 5, **caractérisé en ce que** les ouvertures desdites électrodes (G1-A1-T1, G2-A2-T2, G3-A3-T3) ont une surface comprise entre 15 et 30 mm².

7. Dispositif selon l'une quelconque des revendications 1 à 6, **caractérisé en ce que** lesdites électrodes sont constituées par des grilles (G1, G2, G3).

8. Dispositif selon la revendication 7, **caractérisé en ce que** la transparence desdites grilles (G1, G2, G3) est supérieure à 50%.

9. Dispositif selon l'une quelconque des revendications 7 ou 8 **caractérisé en ce que**, la distance entre deux grilles consécutives étant notée h, le diamètre des orifices desdites grilles étant noté D, le rapport h/D est supérieur à 1.

10. Dispositif selon l'une quelconque des revendications 1 à 6, **caractérisé en ce que** lesdites électrodes sont constituées par des anneaux (A1-T1, A2-T2, A3-T3).

11. Dispositif selon la revendication 10 **caractérisé en ce que**, la distance entre deux anneaux consécutifs étant notée h, le diamètre dudit cylindre de conduction étant noté D, le rapport h/D est supérieur à 1.

12. Dispositif selon l'une quelconque des revendications précédentes
comportant de plus un spectromètre (SPC) pour estimer la proportion d'une espèce ionique prédéterminée, **caractérisé en ce que** ledit circuit de contrôle (CC) comprend des moyens pour affecter ladite proportion audit courant ionique.

13. Dispositif selon l'une quelconque des revendications précédentes, **caractérisé en ce qu'**il comporte au moins un détecteur d'électrons secondaires additionnel.

## Patentansprüche

1. Dosismessvorrichtung für die Ionenimplantation, wobei die Vorrichtung ein Schätzmodul des Implantationsstroms (CUR), einen Detektor von Sekundärelektronen (DSE), einen Überwachungsstromkreis (CC) zur Schätzung des Ionenstroms durch Differenziation des
Implantationsstroms und des vom Detektor von Sekundärelektronen stammenden Stroms aufweist, **dadurch gekennzeichnet, dass** der Detektor von energetischen Sekundärelektronen einen Kollektor (COL, P) aufweist, der ausschließlich drei voneinander isolierte Elektroden trägt:
- eine erste Repeller-Elektrode (G1, A1, T1), um die zu entfernenden Ladungen eines vorbestimmen Vorzeichens zurückzudrängen, wobei diese Elektrode mit mindestens einer Öffnung versehen ist, um den Durchgang der Elektronen zu erlauben,
- eine zweite Repeller-Elektrode (G2, A2, T2), um die zu entfernenden Ladungen des entgegengesetzten Vorzeichens zurückzudrängen, wobei diese Elektrode ebenfalls mit mindestens einer Öffnung versehen ist, um den Durchgang der Elektronen zu erlauben,
- eine Auswahl-Elektrode (G3, A3, T3), wobei diese Elektrode ebenfalls mit mindestens einer Öffnung versehen ist, um den Durchgang der Elektronen zu erlauben.

2. Vorrichtung nach Anspruch 1, **dadurch gekennzeichnet, dass** die Öffnungen der Elektroden auf einen Leitungszylinder (D) ausgerichtet sind, der eine Öffnung des Detektors von Sekundärelektronen (DSE) ist.

3. Vorrichtung nach einem der Ansprüche 1 oder 2, **dadurch gekennzeichnet, dass** der Kollektor (COL) in Form einer Schale vorliegt.

4. Vorrichtung nach einem der Ansprüche 1 bis 3, **dadurch gekennzeichnet, dass** die Elektroden (G1-A1-T1, G2-A2-T2, G3-A3-T3) aus Aluminum sind.

5. Vorrichtung nach einem der Ansprüche 1 bis 4, **dadurch gekennzeichnet, dass** der Zwischenraum wischen zwei aufeinanderfolgenden Elektroden (G1-G2, G2-G3) zwischen 6 und 10 mm liegt.

6. Vorrichtung nach einem der Ansprüche 1 bis 5, **dadurch gekennzeichnet, dass** die öffnungen der Elektroden (G1-A1-T1, G2-A2-T2, G3-A3-T3) eine Fläche zwischen 15 und 30 mm² haben.

7. Vorrichtung nach einem der Ansprüche 1 bis 6, **dadurch gekennzeichnet, dass** die Elektroden aus Gates (G1, G2, G3) bestehen.

8. Vorrichtung nach Anspruch 7, **dadurch gekennzeichnet, dass** die Durchlässigkeit der Gates (G1, G2, G3) höher als 50% ist.

9. Vorrichtung nach einem der Ansprüche 7 oder 8, dadurch gekennzeichet, dass, wenn der Abstand zwischen zwei aufeinanderfolgenden Gates mit h bezeichnet ist, der Durchmesser der öffnungen der Gates mit D bezeichnet ist, das Verhältnis h/D größer als 1 ist .

10. Vorrichtung nach einem der Ansprüche 1 bis 8, **dadurch gekennzeichnet, dass** die Elektroden aus Ringen (A1-T1, A2-T2, A3-T3) bestehen.

11. Vorrichtung nach Anspruch 10, **dadurch gekennzeichnet, dass**, wenn der Abstand zwischen zwei aufeinanderfolgenden Ringen mit h bezeichnet ist, der Durchmesser des Leitungszylinders mit D bezeichnet ist, das Verhältnis h/D größer als 1 ist.

12. Vorrichtung nach einem der vorhergehenden Ansprüche, die zusätzlich ein Spektrometer (SPC) aufweist, um den Anteil einer vorbestimmten Ionenspezies zu schützen, **dadurch gekennzeichnet, dass** der Überwachungsstromkreis (CC) Einrichtungen enthält, um den Anteil dem Ionenstrom zuzuordnen.

13. Vorrichtung nach einem der vorhergehenden Ansprüche, **dadurch gekennzeichnet, dass** sie mindestens einen zusätzlichen Detektor von Sekundärelektronen aufweist.

## Claims

1. A dose-measurement device for ion implantation, the device comprising a module (CUR) for estimating implantation current, a secondary electron detector (DSE), and a control circuit (CC) for estimating the ion current by taking the difference between said implantation current and the current from said secondary electron detector, the device being **characterized in that** said high-energy secondary electron detector comprises a collector (COL, P) supporting exactly three mutually insulated electrodes:
· a first repulsion electrode (G1, A1, T1) for repelling charges of a predetermined sign that are to be repelled, said electrode being provided with at least one orifice for passing electrons;
- a second repulsion electrode (G2, A2, T2) for repelling charges of the opposite sign that are to be repelled, said electrode also being provided with at least one orifice for passing electrons; and
· a selection electrode (G3, A3, T3), this electrode also being provided with at least one orifice for passing electrons.

2. A device according to claim 1, **characterized in that** the orifices in said electrodes are in alignment on a conduction cylinder (D) that is an opening of said electron detector (DSE).

3. A device according to claim 1 or claim 2,
**characterized in that** said collector (COL) is in the form of a cup.

4. A device according to any one of claims 1 to 3, **characterized in that** said electrodes (G1-A1-T1, G2-A2-T2, G3-A3-T3) are made of aluminum.

5. A device according to any one of claims 1 to 4, **characterized in that** the spacing between two consecutive electrodes (G1-G2, G2-G3) lies in the range 6 mm to 10 mm.

6. A device according to any one of claims 1 to 5, **characterised in that** the openings in said electrodes (G1-A1-T1, G2-A2-T2, G3-A3-T3) present an area lying in the range 15 mm² to 30 mm².

7. A device according to any one of claims 1 to 6, **characterized in that** said electrodes are constituted by grids (G1, G2, G3).

8. A device according to claim 7, **characterized in that** the transparency of said grids (G1, G2, G3) is greater than 50%.

9. A device according to claim 7 or claim 8, **characterized in that** the distance between two consecutive grids is written h, the diameter of the orifices in said grids is written D, and the ratio written h/D is greater than 1.

10. A device according to any one of claims 1 to 6, **characterized in that** said electrodes are constituted by rings (A1-T1, A2-T2, A3-T3).

11. A device according to claim 10, **characterized in that** the distance between two consecutive rings is written h, the diameter of said conduction cylinder is written D, and the ratio written h/D is greater than 1.

12. A device according to any preceding claim also including a spectrometer (SPC) for estimating the proportion of a predetermined species of ion, **characterized in that** said control circuit (CC) includes means for applying said proportion to said ion current.

13. A device according to any preceding claim, **characterized in that** it includes at least one additional secondary electron detector.
